# EUROPEAN PATENT APPLICATION

(11) **EP 4 369 537 A2**
(43) Date of publication of application: **15.05.2024**
(21) Application number: 23208553.0
(22) Date of filing: 08.11.2023
(51) Int. Cl.: H01S 5/183, H01S 5/30

(54) **MULTI-JUNCTION BOTTOM EMITTING VERTICAL CAVITY SURFACE EMITTING LASER AND THE FABRICATION METHOD OF THE SAME**

(30) Priority: 10.11.2022 US 202218054186
(71) Applicant: Brightlaser Limited, New Territories (HK)
(72) Inventor: LUO, Yuhui, New Territories, Hong Kong (HK); CHAN, Chuyuen, New Territories, Hong Kong (HK)
(74) Representative: Beck & Rössig European Patent Attorneys

(57) **Abstract**

The present invention discloses a multi-junction bottom emitting vertical cavity surface emitting laser (VCSEL) **(10)** comprising: an electrical n-contact layer **(100);** a semiconductor substrate **(102)** disposed on the electrical n-contact layer **(100);** an etch-stop layer **(104)** disposed on the semiconductor substrate **(102);** a n-type semiconductor distributed Bragg reflector (nDBR) **(106)** including a first plurality of layers of semiconductor material disposed on the etch-stop layer **(104);** a laser cavity comprising of a plurality of active region **(108)** disposed on the nDBR **(106);** a hybrid metal-semiconductor reflector **(110)** disposed on the laser cavity; wherein the hybrid metal-semiconductor reflector **(110)** comprises a p-type semiconductor distributed Bragg reflector (pDBR) **(110a)** including a second plurality of layers of semiconductor material, a phase matching layer **(110b)** disposed on the pDBR **(110a)** and a metallic reflector **(110c)** disposed on the phase matching layer **(110b);** and an electrical p-contact layer **(112)** formed on the hybrid metal-semiconductor reflector **(110).**

## Description

### FIELD OF THE INVENTION

The present invention relates to a bottom emitting vertical cavity surface emitting laser, in particular a multi-junction bottom emitting vertical cavity surface emitting laser with hybrid metal-semiconductor reflector and the fabrication method of the same.

### BACKGROUND OF THE INVENTION

A typical vertical cavity surface emitting laser (VCSEL) has a structure of optical resonant cavity for a component with a direction perpendicular to a plane of substrate and therefore an output laser beam is emitted out from the top and bottom of a mirror. A light-exit mirror typically has slightly lower reflectivity than the opposite of non-exit mirror. Commonly, the typical resonant cavity of the VCSEL, which used distributed Bragg reflector (DBR) of multilayers thin film, is constructed from semiconductor layers. In the typical VCSEL, the mirrors are designed with the light-exit mirror is 98%-99% reflectance, while the non-exit mirror required to succeed in the reflectivity of greater than 99.9% at a predetermined wavelength at normal incidence. On another type of design, the bottom mirror is acted as the light-exit mirror and therefore the top mirror has the higher reflectance acting as the non-exit mirror. A number of DBR with only mirror may range from 36 pairs per stack, up to 44 pairs for the wavelength ranging from 780nm to 980nm to realize a high percentage of reflectance, reckoning on a difference between the refractive indices of layers. Therefore, there is a need to have a simpler way to reduce number of DBR pairs for improving the material quality.

Accordingly, a metallic mirror can be used as reflector in VCSEL. Since the metallic mirror is not transparent, it will act as the non-exit mirror with higher reflectivity than the exit mirror. To attain the reflectivity of metallic mirror with greater than 99.9%, it will depend mainly on the number of DBR pairs and the choice of metal material. The choice of metal depends on the wavelength of interest. The typical metal like Ag, Au or Al, are less than 99.0% reflectance in a certain range of wavelengths of interest. In visible spectrum (380nm - 740nm), the reflectance of Ag is simply about 95% at the wavelength of 380nm. Therefore, within the case of the reflectivity of non-exit mirror cannot reach 99.9% reflectance, this will lead to increase the threshold gain of the laser cavity. Moreover, the gain provided by the active region necessary to realize threshold gain is additionally determined by the roundtrip cavity loss that features the optical absorption and the DBR reflection. Hence, there is a need to have a high reflectance of non-exit mirror VCSEL to reduce the threshold current density.

CN 110829178A discloses an annular-structure lower distributed Bragg reflector vertical cavity surface emitting semiconductor laser under a ring structure. The vertical cavity surface emitting semiconductor laser with a distributed Bragg reflector under the ring structure of the invention is an upper electrode, an ohmic contact layer, an upper distributed Bragg reflector, an oxide confinement layer, an active gain region, and The lower distributed Bragg reflector, the substrate, the lower electrode; the shape of the upper electrode, the oxide confinement layer is a ring with the same inner diameter, the width of the ring is 3 µm to 5 µm, and the outer diameter of the ring is 115 µm ∼ 125 µm. A cylindrical hollow region exists in the central portion of the lower distributed Bragg reflector, the substrate, and the lower electrode. However, said structure is lack of providing high reflectance for the vertical cavity surface emitting semiconductor laser, which will lead to increase the threshold gain of the laser cavity. Therefore, there is a need to provide a structure of vertical cavity surface emitting semiconductor laser with high reflectance to reduce optical absorption loss in bulky half size or more of distributed Bragg reflector, at simultaneously could decrease the threshold current density.

US 2013034117 A1 discloses a method and apparatus including improved vertical-cavity surface-emitting laser. Said apparatus include a semiconductor substrate; a vertical-cavity surface-emitting laser (VCSEL) on the substrate; a first electrical contact formed on the VCSEL; a second electrical contact formed on the substrate, wherein the VCSEL includes: a first resonating cavity having first and second mirrors, at least one of which partially transmits light incident on that mirror, wherein the first second mirrors are electrically conductive. A first layer is between the first mirror and the second mirror and has a first aperture that restricts the path of current flow. A second layer is between the first layer and the second mirror and also restricts the electrical current path. A multiple-quantum-well (MQW) structure is between the first mirror and the second mirror, wherein the first and second apertures act together to define a path geometry of the current through the MQW structure. However, there is no disclosure of increasing the reflectivity in the method and apparatus invention. However, said structure is lack of providing high reflectance for the VCSEL, which will lead to increase the threshold gain of the laser cavity. Therefore, there is a need to provide a structure of VCSEL with high reflectance to reduce optical absorption loss in bulky half size or more of distributed Bragg reflector, at simultaneously could decrease the threshold current density.

CN 113206446 A discloses a method for manufacturing a nitride vertical cavity surface emitting laser based on a conductive oxide DBR (distributed Bragg reflector), wherein the laser comprises a supporting substrate, a first reflector, a current limiting layer, a p-type layer, an active region, an n-type layer, a second reflector and an n electrode which are sequentially stacked; wherein, the first reflector and the second reflector are respectively composed of p-type and n-type conductive oxide DBRs; the distributed Bragg reflector is made of the oxide material with conductivity, is used as the reflector of the nitride vertical cavity surface emitting laser. However, the method is only applicable for nitride material VCSEL structure. Hence, there is a need to have a wider application of DBR material VCSEL structure such as gallium arsenide and indium phosphide.

### SUMMARY OF THE INVENTION

It is an objective of the present invention to provide a multi-junction bottom emitting vertical cavity surface emitting laser with hybrid metal-semiconductor mirror, which can provide high reflectivity and act as non-exit mirror to reduce optical absorption loss in bulky half size or more of DBR.

It is also an objective of the present invention to provide a multi-junction bottom emitting vertical cavity surface emitting laser, which could boost output power by increasing roundtrip gain, hence simultaneously decrease the threshold current density and increase the differential quantum efficiency.

It is also a further objective of the present invention to provide a various DBR material of multijunction bottom vertical cavity surface emitting laser with hybrid metal-semiconductor mirror, which include Gallium Arsenide, GaAs-based substrate, Gallium Nitride, GaN-based substrate, and Indium Phosphide, InP-based substrate.

Accordingly, these objectives may be achieved by following the teachings of the present invention. The present invention relates to a multi-junction bottom emitting vertical cavity surface emitting laser (VCSEL) comprising: an electrical n-contact layer; a semiconductor substrate disposed on the electrical n-contact layer; an etch-stop layer disposed on the semiconductor substrate; a n-type semiconductor distributed Bragg reflector (nDBR) including a first plurality of layers of semiconductor material disposed on the etch-stop layer; a laser cavity comprising of a plurality of active region disposed on the nDBR; a hybrid metal-semiconductor reflector disposed on the laser cavity; wherein the hybrid metal-semiconductor reflector comprises a p-type semiconductor distributed Bragg reflector (pDBR) including a second plurality of layers of semiconductor material, a phase matching layer disposed on the pDBR and a metallic reflector disposed on the phase matching layer, and an electrical p-contact layer formed on the hybrid metal-semiconductor reflector.

### BRIEF DESCRIPTION OF THE DRAWINGS

The features of the invention will be more readily understood and appreciated from the following detailed description when read in conjunction with the accompanying drawings of the preferred embodiment of the present invention, in which:
FIG. 1 illustrates a cross sectional schematic view of a multi-junction bottom emitting vertical cavity surface emitting laser structure of the present invention;
FIG. 2 illustrates a cross sectional schematic view of a mesa of the multijunction bottom-emitting vertical cavity surface emitting laser structure in according to FIG.1;
FIG. 3 illustrates a cross sectional schematic view of after oxidation of a current confinement layer in according to FIG.1;
FIG. 4 illustrates a cross sectional schematic view of the formation of a metallic reflector and a metal electrode in according to FIG. 1.

### DETAILED DESCRIPTION OF THE PREFERRED EMBODIMENT

For the purposes of promoting and understanding of the principles of the invention, reference will now be made to the embodiments illustrated in the drawings and described in the following written specification. It is understood that the present invention includes any alterations and modifications to the illustrated embodiments and includes further applications of the principles of the invention as would normally occur to one skilled in the art to which the invention pertains.

The present invention teaches a multi-junction bottom emitting vertical cavity surface emitting laser (VCSEL) **10** comprising: an electrical n-contact layer **100**; a semiconductor substrate **102** disposed on the electrical n-contact layer **100**; an etch-stop layer **104** disposed on the semiconductor substrate **102**; a n-type semiconductor distributed Bragg reflector (nDBR) **106** including a first plurality of layers of semiconductor material disposed on the etch-stop layer **104**; a laser cavity comprising of a plurality of active region **108** disposed on the nDBR **106**; a hybrid metal-semiconductor reflector **110** disposed on the laser cavity; wherein the hybrid metal-semiconductor reflector **110** comprises a p-type semiconductor distributed Bragg reflector (pDBR) **110a** including a second plurality of layers of semiconductor material, a phase matching layer **110b** disposed on the pDBR **110a** and a metallic reflector **110c** disposed on the phase matching layer **110b**; and an electrical p-contact layer **112** formed on the hybrid metal-semiconductor reflector **110**.

In a preferred embodiment of the present invention, the electrical n-contact layer **100**, the semiconductor substrate **102** and the etch-stop layer **104** are configured as a ring shape with an emitting window **114** for emitting laser and the electrical p-contact **112** layer is for current injection.

In a preferred embodiment of the present invention, the nDBR **106**, the etch-stop layer **104**, the semiconductor substrate **102** and the electrical n-contact layer **100** are configured as a mesa extending out with a circular cross-section.

In a preferred embodiment of the present invention, the hybrid metal-semiconductor reflector **110** is a non-exit mirror and the nDBR **106** is a light-exit mirror. The nDBR **106** and pDBR **110a** layer comprises Indium aluminum gallium arsenide (InAlGaAs) on Gallium Arsenide (GaAs)-based substrate, Indium aluminum gallium nitride (InAlGaN) on Gallium Nitride (GaN)-based substrate, and Indium aluminum gallium arsenide (InAlGaAs) on Indium Phosphide (InP)-based substrate.

In a preferred embodiment of the present invention, each layer of the plurality of active region **108** in the laser cavity comprises of a multiple of strained or unstrained quantum well **108a** structure. Each multiple of strained or unstrained quantum well **108a** structure is spaced apart from one another wherein they are electrically conductively connected by a tunnel junction **108c** and confined by a current confinement layer **108b**. The tunnel junction **108c** comprises at least two doped semiconductor layers of different conduction types. And a current confinement aperture **108d** is formed on the current confinement layer **108c** by wet oxidation.

In a preferred embodiment of the present invention, the metallic reflector **110c** comprises at least one layer of metal or at least one layer of alloy wherein the metal comprises gold, silver, copper, aluminum, nickel, titanium, chromium or platinum and the alloy comprise gold, silver, copper, aluminum, nickel, titanium, chromium or platinum.

The present invention also teaches a method of fabricating multi-junction bottom emitting vertical cavity surface emitting laser (VCSEL) **10**, comprising the steps of: providing a semiconductor substrate **102**; epitaxially disposing an etch-stop layer **104** on the semiconductor substrate **102**; epitaxially disposing a n-type semiconductor distributed Bragg reflector (nDBR) **106** including a first plurality of layers of semiconductor material on the etch-stop layer **104**; epitaxially disposing a plurality of active region **108** comprising a multiple quantum well **108a** structure on the nDBR **106**; epitaxially disposing a p-type semiconductor distributed Bragg (pDBR) **110a** reflector including a second plurality of layers of semiconductor material and a phase matching layer **110b** in aligned consecutive order on the plurality of active region **108**; forming a mesa on the nDBR **106**, the etch-stop layer **104** and the semiconductor substrate **102**; disposing the metallic reflector **108** on the phase matching layer **110b**; forming an electrical p-contact layer **112** on the metallic reflector **108** for current injection; thinning and selectively removing the semiconductor substrate **102** and the etch-stop layer **104**; and forming an electrical n-contact layer **100** on the backside of the semiconductor substrate **102**. Said method further comprising forming an emitting window **114** in the electrical n-contact layer **100**, the semi-conductor substrate **102** and the etch-stop layer **104** for emitting laser. The forming of the mesa on the nDBR **106**, the etch-stop layer **104** and the semiconductor substrate **102** is by dry or wet etching

In a preferred embodiment of the present invention, the epitaxially disposing of each of the plurality of active region **108** further comprising the steps of forming a tunnel **108c** junction for connecting the multiple quantum well **108a** structure and forming a current confinement layer **108b** for confining the current injection. Said method of forming the current confinement layer **108b** further comprising the steps of oxidizing the current confinement layer **108b** and forming a current confinement aperture **108d** on the current confinement layer **108b**.

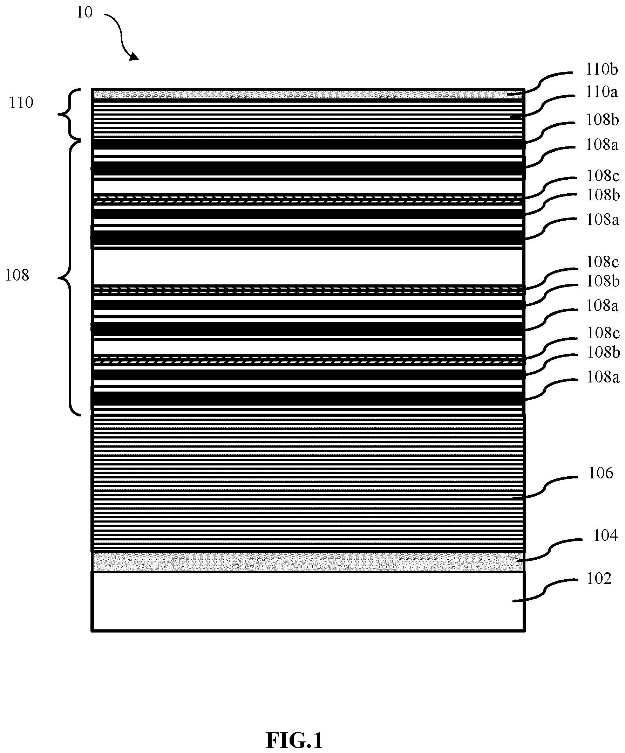

A cross sectional schematic view of the epitaxy structure design of a multijunction bottom emitting vertical cavity surface emitting laser **10** structure is illustrated in **FIG.1****.** As illustrated in **FIG.1**, an etch-stop layer **104**, a n-type semiconductor distributed Bragg reflector (nDBR) **106**, a plurality of active region **108** and a hybrid metal-semiconductor reflector **110** are epitaxially formed on a semiconductor substrate **102**. The hybrid metal-semiconductor reflector **110** includes but not limited to a p-type semiconductor distributed Bragg reflector (pDBR) **110a** layer and a phase matching layer **110b**.

Both the pDBR **110a** and nDBR **106** layers are formed by semiconductor material of different refractive index. The semiconductor DBR used is in two layers of materials of different refractive indices with proper lasing wavelength to design the thickness and pair number for resonant cavity. The semiconductor material of both the pDBR **110a** and nDBR **106** are lattice-match to the substrate. The substrate can be, for example, GaAs, InP or GaN substrate. The hybrid metal-semiconductor reflector **110** is a non-exit mirror and the nDBR **106** is a light-exit mirror.

As further illustrated in **FIG.1**, the active region **108** includes but not limited to a multiple quantum well **108a**, a current confinement layer **108b** and a tunnel junction **108c**. Each active region **108** is formed by a multiple of strained or unstrained quantum well **108a** being separated from each other by barrier layers, depending on the application for which the multijunction bottom emitting VCSEL **10** is designed. Each of the multiple of strained or unstrained quantum well **108a** structure is spaced apart from one another wherein they are electrically conductively connected by the tunnel junction **108c** and confined by the current confinement layer **108b**. Therefore, in the plurality of active region **108**, it can be designed with different number of active regions **108**. Each active region **108** has different number of multiple quantum wells **108a**. Each quantum well **108a** has a gain spectrum with the same peak gain. The tunnel junction **108c** comprises at least two doped semiconductor layers of different conduction type with the thickness of 20-40nm.

A high-performance tunnel junction **108c** requires materials with high p-type and n-type doping level with low resistance and low absorption loss. The tunnel junction **108c** is reverse biased during the operation of the VCSEL **10**. Current moves across such a junction by tunnelling effect, but a potential difference is still required across the junction. Hence, the potential across the VCSEL **10** must be increased to provide the required current through the tunnelling junction **108c**. To provide adequate tunnelling effect, the layers of the tunnel junction **108c** must be very heavily doped, i.e., dopant concentrations of 1 × 10¹⁹cm⁻³ or higher are required for both the n- and p-type impurities, on opposite sides of the tunnel junction **108c**.

The dopants for the p-type heavily doped layer can be carbon, zinc, beryllium or magnesium. For the p-type heavily doped layer, the elements used to form the tunnel junction **108c** in the present invention include but not limited to carbon. Doping elements of the n-type heavily doped layer can be, for example, silicon or tellurium. For the n-type heavily doped layer, the elements used to form the tunnel junction **108c** include but not limited to tellurium.

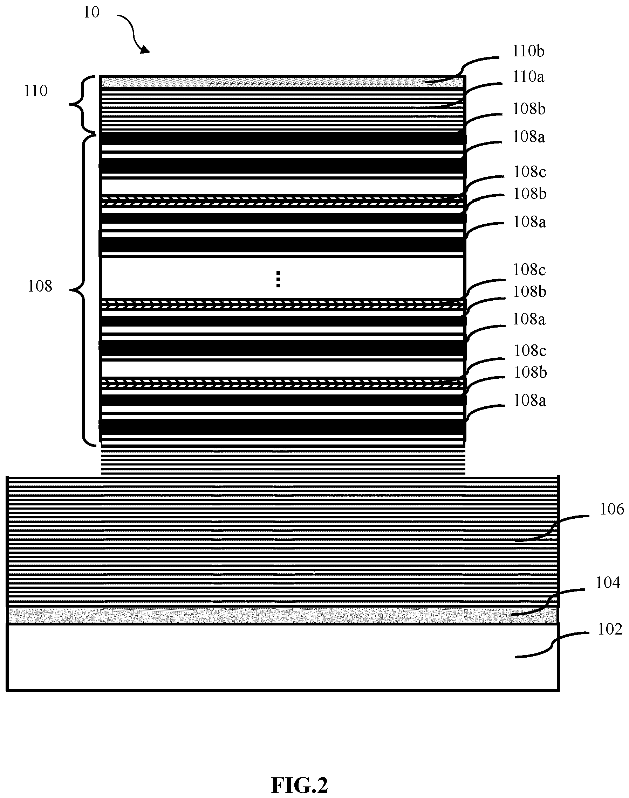

The first part of the hybrid metal-semiconductor reflector **110** is epitaxially growing the pDBR **110a** and the phase matching layer **110b** as disclosed above. Accordingly, a cross sectional schematic view of a mesa of the multi-junction bottom-emitting vertical cavity surface emitting laser **10** structure is illustrated in **FIG.2**. A mesa is etched below the plurality of active region **108** and stopped at the beginning of nDBR **106** layer. The mesa is formed by any suitable processes such as dry or wet etching. A typical dry etch processes use oxygen, chlorine, argon, nitrogen, and helium ions, whereas wet etch processes use sulphuric or phosphide acid etches. In the present embodiment, the mesa is dry etched with an inductively coupled plasma and the mesa may range from 20 to 50 microns, or preferably about 30 to 40 microns in diameter. The mesa has a generally circular cross-section.

A current confinement aperture **108d** is formed on the current confinement layer **108b** by wet oxidizing to reduce the threshold current of the multi-junction VCSEL **10**.

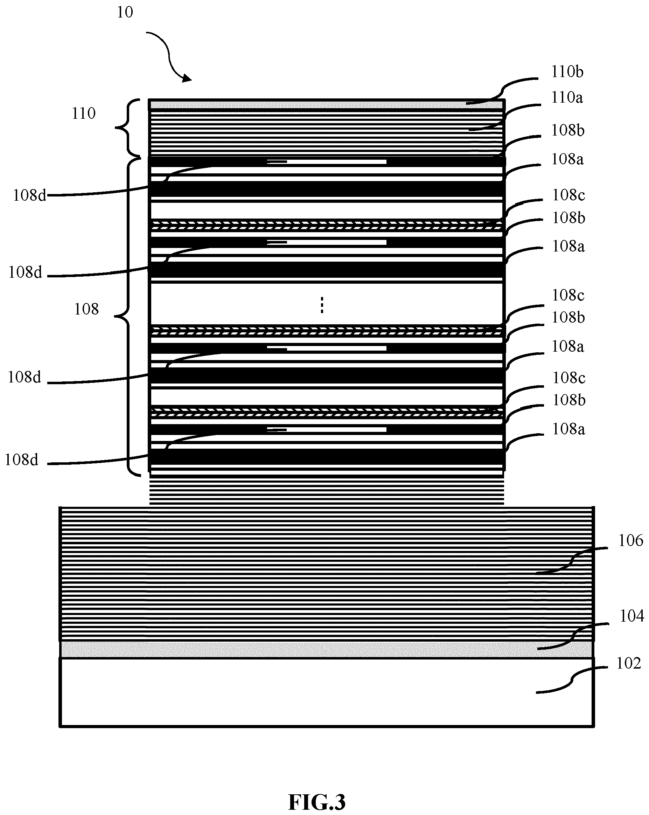

**FIG. 3** illustrates a cross sectional schematic view of after oxidation of a current confinement layer **108b**. The oxidized outer portion of the current confinement aperture **108d** generally has an annular shape with the oxidation extending symmetrically inward from the etched sidewalls of a mesa. The current confinement aperture **108d** is therefore centered in the mesa.

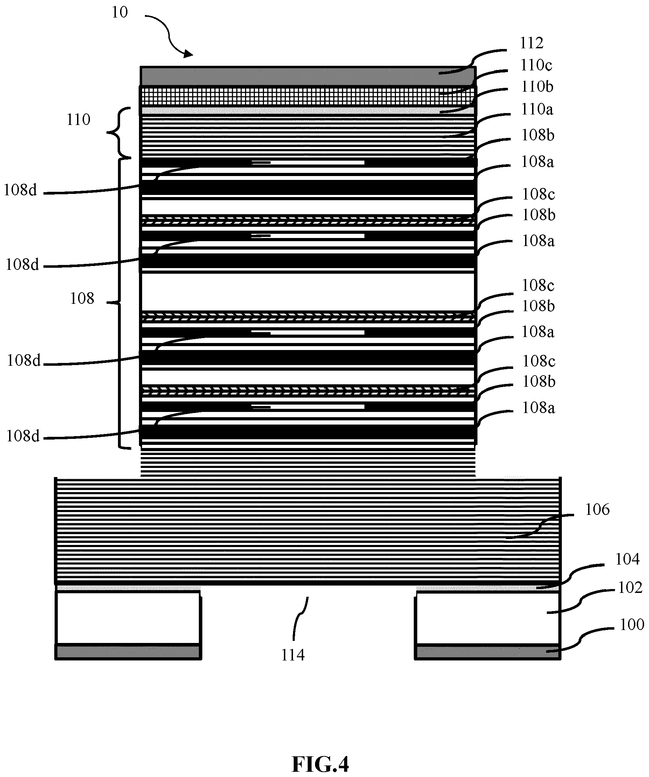

The hybrid metal-semiconductor reflector **110** also includes a metallic reflector **110c** which is then deposited on the phase matching layer **110b** after the process of mesa etching. **FIG. 4** illustrates a cross sectional schematic view of the formation of the metallic reflector **110c** and a metal electrode on the hybrid metal-semiconductor reflector **110**. As shown in **FIG.4**, the hybrid metal-semiconductor reflector **110** also includes a metallic reflector **110c** such as metallic mirror with the metals made of material like gold, silver, copper, aluminum, nickel, titanium, chromium, platinum, other than the phase matching layer **110b** and the plurality of pDBR **110a** pairs with different refractive indices, from top to bottom. However, the metallic mirror **110c** also can be formed in multiple layers of metals or at least an alloy that is selected from gold, silver, copper, aluminum, nickel, titanium, chromium, platinum. The pDBR layers **110a** will be used in combination with the metallic mirror **110c** for obtaining high reflectivity of hybrid metal-semiconductor mirror **110**. It will cause a half sized DBR than a DBR-only mirror. Therefore, the present invention provides a fabrication of a multi-junction bottom emitting VCSEL **10** with hybrid metal-semiconductor mirror **110**, to provide a composite and high-reflectance top mirror.

The conductivity of metals like gold, silver, platinum is not infinite and as light is incident on the metal surface it can penetrate a few tens of nanometers into the metal films. Thus, the phase change of light reflection from metallic film not only undergoes π but also an extra shift due to penetration. To maximize the reflection of light, this phase shift should be compensated for, which can be realized by inserting a phase-matching layer **110b** in the present invention. Therefore, said phase-matching layer **110b** is disposed in between the metallic mirror **110c** and the pDBR **110a**. The reflected light from a metallic mirror **110c** has a phase shift depending on the properties of the metal multilayer used. Therefore, it is preferable to have a phase shift adaptive laser between pDBR **110a** and the metallic mirror **110c** to adjust the standing wave function, so that reflections from the metallic mirror **110c** and the pDBR **110a** are phase matched at the lasing wavelength to achieve the maximum overall reflectance. Phase-matching layer **110b** may include but not limited to a semiconductor material. It is considered as part of pDBR **110a**, since it plays a role in the overall reflectance attained by the hybrid metal-semiconductor mirror **110**. A suitable thickness for the phase-matching layer **110b** is less than or equal to about one-half wavelength of lasing operation reflected by the top and bottom mirror.

Since the adhesion of metal onto a semiconductor is known to be challenging, it is usual to first metallize, for example, the GaAs with a material like titanium or chromium which has a much stronger bond with GaAs. However, the adhesion layer may be very detrimental for the metallic mirror as the reflectivity drop by thickness. The thickness of this adhesion layer can vary greatly but is generally chosen to be between about 5-40 nm. Other adhesive layers such as palladium or nickel, or the like can also be substituting said layer.

Furthermore, an electrical p-contact **112** is plated on the metallic mirror **110c**, whereas an electrical n-contact **100** is plated on the back side of the substrate **102** as further illustrated in **FIG.4**. In an exemplary embodiment of the present invention, titanium, platinum and gold multilayer are used for the electrical p-contact **112** and germane gold, nickel and gold multilayer are used for electrical n-contact **100** conductivity for the bonding layer to form the ohmic contact in n-type or p-type contacts. The multi-junction VCSEL **10** with hybrid metal-semiconductor mirror **110** is activated by applying current through the top electrical p-contact **112** and bottom electrical n-contact **100**.

The back side of substrate **102** and etch-stop layer **104** are selectively thinned and removed to form a bottom-emitting window **114.** The removal of the substrate **102** is performed using a selective etching method with respect to etch stop layer **104**. The completed multi-junction bottom-emitting VCSEL **10** with hybrid metal-semiconductor mirror **110** device is diced using any of the standard dicing techniques to separate the individual VCSEL device or VCSEL arrays into chips to be mounted on the heat spreader sub-mount.

The method and system in the present invention provides a half sized DBR to form a multi-junction bottom emitting VCSEL **10**. The reduction of the number of semiconductors DBR thickness resulted in a good thermal conductivity. The multijunction bottom emitting VCSEL **10** structure is provided in the present invention to reduce threshold current and heighten output power by increasing the roundtrip gain for improving the low roundtrip gain in the common VCSEL cavity that requires high mirror reflectivity. The threshold current density is further reduced in the present invention when further plurality of active regions is added to this structure. In principle, there is no limitation in adding this kind of active regions in multi-junction VCSEL **10**.

The present invention explained above is not limited to the aforementioned embodiment and drawings, and it will be obvious to those having an ordinary skill in the art of the prevent invention that various replacements, deformations, and changes may be made without departing from the scope of the claims.

## Claims

1. A multi-junction bottom emitting vertical cavity surface emitting laser (VCSEL) (10), comprising:
an electrical n-contact layer (100);
a semiconductor substrate (102) disposed on the electrical n-contact layer (100);
an etch-stop layer (104) disposed on the semiconductor substrate (102);
a n-type semiconductor distributed Bragg reflector (nDBR) (106) including a first plurality of layers of semiconductor material disposed on the etch-stop layer (104);
a laser cavity comprising of a plurality of active region (108) disposed on the nDBR (106);
a hybrid metal-semiconductor reflector (110) disposed on the laser cavity;
wherein the hybrid metal-semiconductor reflector (110) comprises a p-type semiconductor distributed Bragg reflector (pDBR) (110a) including a second plurality of layers of semiconductor material, a phase matching layer (110b) disposed on the pDBR (110a) and a metallic reflector (110c) disposed on the phase matching layer (110b); and
an electrical p-contact layer (112) formed on the hybrid metal-semiconductor reflector.

2. The multi-junction bottom emitting VCSEL (10) according to claim 1, wherein the electrical n-contact layer (100), the semiconductor substrate (102) and etch-stop layer (104) are configured as a ring shape with an emitting window (114) for emitting laser and the electrical p-contact layer (112) is for current injection.

3. The multi-junction bottom emitting VCSEL (10) according to claim 1 or 2, wherein the nDBR (106), the etch-stop layer (104), the semiconductor substrate (102) and the electrical n-contact layer (100) are configured as a mesa extending out with a circular cross-section.

4. The multi-junction bottom emitting VCSEL (10) according to one of claims 1 to 3, wherein the hybrid metal-semiconductor reflector (110) is configured as a non-exit mirror and the nDBR (106) is configured as a light-exit mirror.

5. The multi-junction bottom emitting VCSEL (10) according to one of claims 1 to 4, wherein each of the first plurality of layers of semiconductor material in the nDBR (106) comprises Indium aluminum gallium arsenide (InAlGaAs) on Gallium Arsenide (GaAs)-based substrate, Indium aluminum gallium nitride (InAlGaN) on Gallium Nitride (GaN)-based substrate, and Indium aluminum gallium arsenide (InAlGaAs) on Indium Phosphide (InP)-based substrate.

6. The multi-junction bottom emitting VCSEL (10) according to claim 1, wherein each of the second plurality of layers of semiconductor material in the pDBR (110a) comprises Indium aluminum gallium arsenide (InAlGaAs) on Gallium Arsenide (GaAs)-based substrate, Indium aluminum gallium nitride (InAlGaN) on Gallium Nitride (GaN)-based substrate, and Indium aluminum gallium arsenide (InAlGaAs) on Indium Phosphide (InP)-based substrate.

7. The multi-junction bottom emitting VCSEL (10) according to one of claims 1 to 6, wherein each layer of the plurality of active region (108) in the laser cavity comprises of a multiple of strained or unstrained quantum well (108a) structure.

8. The multi-junction bottom emitting VCSEL (10) according to claim 7, wherein each multiple of strained or unstrained quantum well (108a) structure is spaced apart from one another wherein they are electrically conductively connected by a tunnel junction (108c) and confined by a current confinement layer (108b).

9. The multi-junction bottom emitting VCSEL (10) according to claim 8, wherein the tunnel junction (108c) comprises at least two doped semiconductor layers of different conduction types.

10. The multijunction bottom emitting VCSEL (10) according to claim 8 or 9, further comprising a current confinement aperture (108d) formed on the current confinement layer (108b) by wet oxidation.

11. The multi-junction bottom emitting VCSEL (10) according to one of claims 1 to 10, wherein the metallic reflector (110c) comprises at least one layer of metal or at least one layer of alloy;
preferably, the metal comprises gold, silver, copper, aluminum, nickel, titanium, chromium or platinum and the alloy comprises gold, silver, copper, aluminum, nickel, titanium, chromium or platinum.

12. A method of fabricating multi-junction bottom emitting vertical cavity surface emitting laser (VCSEL) (10), comprising the steps of:
providing a semiconductor substrate (102);
epitaxially disposing an etch-stop layer (104) on the semiconductor substrate (102);
epitaxially disposing a n-type semiconductor distributed Bragg reflector (nDBR) (106) including a first plurality of layers of semiconductor material on the etch-stop layer (104);
epitaxially disposing a plurality of active region (108) comprising a multiple quantum well (108a) structure on the nDBR(106);
epitaxially disposing a p-type semiconductor distributed Bragg (pDBR) (110a) reflector including a second plurality of layers of semiconductor material and a phase matching layer (110b) in aligned consecutive order on the plurality of active region (108);
forming a mesa on the nDBR (106), the etch-stop layer (104) and the semiconductor substrate (102);
disposing the metallic reflector (110c) on the phase matching layer (110b);
forming an electrical p-contact layer (112) on the metallic reflector (110c) for current injection;
thinning and selectively removing the semiconductor substrate (102) and the etch-stop layer (104); and
forming an electrical n-contact layer (100) on the backside of the semiconductor substrate (102).

13. The method of fabricating multi-junction bottom emitting VCSEL (10) according to claim 12, further comprising forming an emitting window (114) in the electrical n-contact layer (100), the semi-conductor substrate (102) and the etch-stop layer (104) for emitting laser.

14. The method of fabricating multi-junction bottom emitting VCSEL (10) according to claim 12 or 13, wherein the forming of the mesa on the nDBR (106), the etch-stop layer (104) and the semiconductor substrate (102) is by dry or wet etching.

15. The method of fabricating multi-junction bottom emitting VCSEL (10) according to one of claims 12 to 14, wherein the epitaxially disposing of each of the plurality of active region (108) further comprising the steps of forming a tunnel junction (108c) for connecting the multiple quantum well (108a) structure and forming a current confinement layer (108b) for confining the current injection;
preferably, the forming of the current confinement layer (108b) further comprising the steps of oxidizing the current confinement layer (108b) and forming a current confinement aperture (108d) on the current confinement layer (108b).
